# EUROPÄISCHE PATENTSCHRIFT

(11) **EP 2 355 126 B1**
(45) Veröffentlichungstag und Bekanntmachung des Hinweises auf die Patenterteilung: **02.12.2015**
(21) Anmeldenummer: 10011124.4
(22) Anmeldetag: 19.01.2006
(51) Int. Cl.: H01J 37/32, C23C 14/32, C23C 14/08, C23C 28/04, F01D 5/28

(54) **Hartstoffschicht**
Hard material layer
Couche dure

(30) Priorität: 24.03.2005 CH 518052005; 03.08.2005 CH 12892005
(43) Veröffentlichungstag der Anmeldung: 10.08.2011
(62) Teilanmeldung aus: 06700563.7
(73) Patentinhaber: Oerlikon Surface Solutions AG, Trübbach, 9477 Trübbach (CH)
(72) Erfinder: Ramm, Juergen, CH-7304 Maienfeld (CH); Widrig, Beno, CH-7310 Bad Ragaz (CH); Kalss, Wolfgang, A-6800 Feldkirch (AT)
(74) Vertreter: Troesch Scheidegger Werner AG

(56) Entgegenhaltungen:
- EP-A1- 1 186 681
- DE-A1- 4 401 986
- US-A1- 2003 209 424
- W D SPROUL: "High-rate reactive DC magnetron sputtering of oxide and nitride superlattice coatings", VACUUM, Bd. 51, Nr. 4, 1. Dezember 1998 (1998-12-01), Seiten 641-646, XP55006553,
- TAKIKAWA H ET AL: "Properties of titanium oxide film prepared by reactive cathodic vacuum arc deposition", THIN SOLID FILMS, ELSEVIER-SEQUOIA S.A. LAUSANNE, CH, Bd. 348, Nr. 1-2, 6. Juli 1999 (1999-07-06), Seiten 145-151, XP004177574, ISSN: 0040-6090, DOI: 10.1016/S0040-6090(99)00054-1

## Beschreibung

Die Erfindung bezieht sich auf eine Hartstoffschicht als oxidische Arc - PVD Funktionsschicht (32) abgeschieden auf ein Werkstück (30) gemäss dem Oberbegriff von Anspruch 1 sowie auf ein Verfahren zur Beschichtung eines Werkstückes mit einer Hartstoffschicht gemäss dem Oberbegriff von Anspruch 6 und auf eine Vakuumbehandlungsanlage gemäss Anspruch 10.

Der Betrieb von Arcverdampferquellen, auch als Funkenkathoden bekannt, durch Speisen mit elektrischen Pulsen ist aus dem Stand der Technik schon seit längerer Zeit bekannt. Mit Arcverdampferquellen können wirtschaftlich hohe Verdampfungsraten und somit hohe Abscheideraten bei der Beschichtung erzielt werden. Ausserdem ist der Aufbau einer derartigen Quelle technisch relativ einfach zu realisieren. Diese Quellen arbeiten bei Strömen typischerweise im Bereich von etwa 100A und mehr und bei Spannungen von einigen Volt bis einigen 10 Volt, welche mit relativ kostengünstigen Gleichstromversorgungen realisiert werden können. Ein wesentlicher Nachteil bei diesen Quellen besteht darin, dass es im Bereich des Kathodenfleckes zu sehr rasch verlaufenden Aufschmelzungen an der Targetoberfläche kommt, wodurch Tropfen gebildet werden, so genannte Droplets, welche als Spritzer weggeschleudert werden und dann am Werkstück kondensieren und die Schichteigenschaften somit unerwünscht beeinflussen. Beispielsweise wird dadurch die Schichtstruktur inhomogen und die Oberflächenrauhigkeit schlecht. Bei hohen Anforderungen an die Schichtqualität können derartig erzeugte Schichten oft kommerziell nicht eingesetzt werden. Es wurde deshalb bereits versucht diese Probleme zu reduzieren indem die Arcverdampferquelle im reinen Pulsbetrieb der Stromversorgung betrieben wird. Allerdings konnten bisher nur marginale Verbesserungen bei der Spritzerbildung damit erreicht werden.

Die Verwendung von reaktiven Gasen zur Abscheidung von Verbindungen ab einem metallischen Target in einem reaktiven Plasma war bis anhin nur auf die Herstellung elektrisch leitfähiger Schichten eingeschränkt. Bei der Herstellung von elektrisch nicht-leitenden, also dielektrischen Schichten wie bspw. von Oxide unter Verwendung von Sauerstoff als Reaktivgas, verstärkt sich das Problem der Spritzerbildung. Die dem Prozess in diesem Fall inhärente Wiederbelegung der Targetoberflächen des Arcverdampfers und der Gegenelektroden, wie den Anoden und auch anderen Teilen der Vakuumprozessanlage mit einer nicht-leitenden Schicht führt zu völlig instabilen Verhältnissen und gar zum Auslöschen des Lichtbogens. In diesem Fall müsste dieser dann immer wieder neu gezündet werden oder die Prozessführung wird dadurch gänzlich verunmöglicht.

In der EP 0 666 335 B1 (entspr. DE 44 01 986 A1) wird für die Abscheidung von rein metallischen Materialien mit einem Arcverdampfer vorgeschlagen, dem Gleichstrom einen pulsierenden Strom zu überlagern, um hierdurch den DC - Grundstrom erniedrigen zu können zur Reduzieren der Spritzerbildung. Hierbei sind Pulsströme bis zu 5000A notwendig, welche mit Kondensatorentladungen erzeugt werden sollen bei relativ tiefen Pulsfrequenzen im Bereich von 100Hz bis 50kHz. Dieses Vorgehen wird vorgeschlagen zur Verhinderung der Dropletbildung beim nicht-reaktiven Verdampfen von rein metallischen Targets mit einer Arcverdampferquelle. Eine Lösung zur Abscheidung von nicht-leitenden, dielektrischen Schichten wird in dieser Schrift nicht angegeben.

Bei der reaktiven Beschichtung mittels Arcverdampferquellen besteht eine mangelnde Reaktivität und Prozesstabilität, besonders bei der Herstellung isolierender Schichten. Im Gegensatz zu anderen PVD Prozessen (z.B. Sputtern), lassen sich isolierende Schichten mittels Arcverdampfung bis heute nur mit elektrisch leitenden Targets herstellen. Ein Arbeiten mit Hochfrequenz, wie es beim Sputtern der Fall ist, scheitert bisher an der fehlenden Technik, Hochstromversorgungen mit hohen Frequenzen betreiben zu können. Das Arbeiten mit gepulsten Stromversorgungen scheint eine Option zu sein. Allerdings muss dann der Funken, wie erwähnt, immer wieder gezündet werden oder die Pulsfrequenz muss so gross gewählt werden, dass der Funke nicht verlischt. Das scheint bei Anwendungen für spezielle Materialien, beispielsweise mit Graphit, wie in DE 3901401 beschrieben, zu funktionieren. Allerdings muss angemerkt werden, dass Graphit kein Isolator ist, sondern elektrisch leitfähig, wenn auch schlechter leitfähig als normale Metalle.

Bei oxidierten Targetoberflächen ist ein neuerliches Zünden über mechanischen Kontakt und mittels DC - Versorgungen nicht möglich. Das eigentliche Problem bei der reaktiven Arcverdampfung sind die Belegungen mit isolierenden Schichten auf Target und auf der Anode bzw. der als Anode geschalteten Beschichtungskammer. Diese isolierenden Belegungen erhöhen im Verlaufe ihrer Bildung die Brennspannung der Funkenentladung, führen zu vermehrten Spritzern und Überschlägen, einem instabilen Prozess, der in einem Unterbruch der Funkenentladung endet. Einher geht eine Belegung des Targets mit Inselwachstum, das die leitende Oberfläche verringert. Ein stark verdünntes Reaktivgas (z.B. Argon/Sauerstoff-Gemisch) kann das Zuwachsen am Target verzögern, aber das grundsätzliche Problem der Prozessinstabilität nicht lösen. Der Vorschlag gemäss der US 5,103,766, die Kathode und die Anode wechselweise zu betreiben mit jeweilig neuerlichem Zünden, trägt wohl zur Prozessstabilität bei, führt aber zu vermehrten Spritzern.

Der Ausweg über eine gepulste Stromversorgung wie es etwa beim reaktiven Sputtern möglich ist, kann bei einer klassischen Funkenverdampfung nicht gegangen werden. Das liegt daran, dass eine Glimmentladung "länger lebt" als ein Funke, wenn man die Stromzufuhr unterbricht.

Um dem Problem der Belegung des Targets mit einer isolierenden Schicht aus dem Weg zu gehen, wird bei reaktiven Prozessen zur Herstellung isolierender Schichten entweder der Reaktivgaseinlass vom Target örtlich getrennt (dann ist die Reaktivität des Prozesses nur gewährleistet, falls auch die Temperatur am Substrat eine Oxidation/Reaktion ermöglicht) oder es wird eine Trennung zwischen Spritzern und ionisiertem Anteil vorgenommen (sog. filtered arc) und das Reaktivgas nach der Filterung dem ionisiertem Dampf beigegeben.

Weiter besteht der Wunsch der weiteren Reduktions- bzw. Skalierbarkeitsmöglichkeit der thermischen Belastung der Substrate und die Möglichkeit Niedertemperaturprozesse bei der kathodichen Funkenbeschichtung zu führen.

In der WO-03018862 wird der Pulsbetrieb von Plasmaquellen als ein möglicher Weg beschrieben, die thermische Belastung am Substrat zu reduzieren. Allerdings gelten dort die Begründungen wohl für den Bereich der Sputterprozesse. Es wird kein Bezug zur Funkenverdampfung hergestellt.

In der Veröffentlichung von Takikawa H et al. ("Properties of titanium oxide film prepared by reactive cathodic arc deposition": Thin Solid Films, Elsevier-Sequuoia S.A. Lausanne CH, Bd. 348, Nr 1-2, 6. Juli1999, Seiten 145-151, XP004177574) wird die Herstellung von Titan Oxid Schichten beschrieben mit einer derartigen Arc-Verdampferquelle mit "filtered arc" und verglichen mit einer konventionellen Arc Verdampferquelle mit "unfiltered arc". Die Arcverdampfer mit metallischem Titantarget werden mit Gleichspannung betrieben und es wird Sauerstoff in die Vakuumkammer eingelassen für die reaktive Abscheidung von Titanoxid. Zur Verringerung der entstehenden macropartikel (droplets) wird bei der vorgestellten Anordnung der Arcverdampfer am Ende eines gekrümmten Zylinders angeordnet, derart dass das Target der Quelle keine Sichtverbindung mit dem Substrat aufweist. Mit einem Magnetfeld entlang des gekrümmten Zylinders wird das Plasma des Arcverdampfers in Richtung des zu beschichtenden Substrates geführt wobei der Sauerstoff in Substratnähe eingelassen wird. Hierdurch soll der Bereich des Targets und der Bereich des Substrates mit dem Sauerstoff örtlich getrennt werden und somit die Dropletbildung am Substrat verhindert werden. Um die Schicht besser durchoxidieren zu können ist hinter dem Substrat eine Heizanordung angebracht zur Aufheizung des Substrates (annealing).

Eine Vakuumanlage zur Beschichtung von Werkstücken mit einem Arcverdampfer ist in der EP 1 186 681 A1 beschrieben. Hierbei ist auch die Möglichkeit dargestellt die Flexibilität der Anlage zu erhöhen indem eine zusätzliche Niedervoltbogen-Entladungsanordnung vorgesehen wird. Mit dem zusätzlichen Niedervoltbogen kann in derselben Anlage einerseits geätzt, gesputtert oder ionenunterstützt beschichtet (Ionplating) werden und andererseits können mit dem Arcverdampfer Schichten abgeschieden werden. Diese Prozesse können nacheinander oder auch gleichzeitig erfolgen bzw. es können auch fliessende Übergänge durchgeführt werden.

Für den Anwendungsbereich von Hartstoffbeschichtungen besteht insbesondere seit langem das Bedürfnis oxidische Hartstoffe mit entsprechender Härte, Haftfestigkeit und gesteuert nach den gewünschten tribologischen Eigenschaften herstellen zu können. Eine wichtige Rolle könnten hierbei Aluminiumoxide, insbesondere Aluminiumchromoxide spielen. Der bisherige Stand der Technik auf dem Gebiet des PVD (Physical Vapor Deposition) beschäftigt sich hierbei meist nur mit der Herstellung von gamma- und alpha-Aluminiumoxid. Das meistgenannte Verfahren ist Dual Magnetron Sputtering, das bei dieser Anwendung grosse Nachteile besitzt in Bezug auf Prozesszuverlässigkeit und Kosten. Japanische Patente konzentrieren sich mehr auf Schichtsysteme in Verbindung mit den Werkzeugen und nennen beispielsweise den Arc-IonPlating-Prozess als Herstellungsmethode. Es besteht der generelle Wunsch alpha-Aluminiumoxid abscheiden zu können. Bei den gängigen PVD-Verfahren sind aber dafür Substrattemperaturen von ca. 700°C oder mehr nötig, um diese Struktur zu erhalten. Einige Anwender versuchen, diese hohen Temperaturen durch Nukleationsschichten eleganterweise zu vermeiden (Oxidation von TiAlN, Al-Cr-O-System). Das macht aber die Prozesse nicht unbedingt billiger und schneller. Bis heute schien es auch nicht möglich mittels Arcverdampfung alpha-Aluminiumoxid-Schichten zufriedenstellend herstellen zu können.

In Bezug zum Stand der Technik werden zusammenfassend folgende Nachteile aufgeführt, insbesondere in Bezug auf die Herstellung von oxidischen Schichten mit reaktivem Prozess:
1. Es ist keine stabile Prozessführung möglich zur Abscheidung isolierender Schichten, falls nicht eine räumliche Trennung zwischen Arcverdampferkathode bzw. Anode der Arcenentladung und dem Substratbereich mit Reaktivgaseinlass gegeben ist.
2. Es besteht keine grundsätzliche Lösung der Spritzerproblematik: Konglomerate (Spritzer) werden nicht voll durchreagiert wobei es zu metallischen Anteilen in der Schicht kommt, eine erhöhte Rauhigkeit der Schichtoberfläche entsteht und die Gleichförmigkeit der Schichtstruktur und Stöchiometrie gestört wird.
3. Unzureichende Möglichkeiten Niedertemperaturprozesse zu realisieren, da die thermische Belastung der Substrate ungenügend für die Herstellung von Oxiden mit Hochtemperaturphasen zu gross ist.
4. Die Herstellung von flach gradierten Zwischenschichten für isolierende Schichten mittels Arcverdampfung war bisher nicht möglich.

Im Gegensatz zum Sputtern ist die Beschichtung mittels kathodischem Funken im Wesentlichen ein Verdampfungsprozess. Man vermutet, dass im Übergang zwischen heissem Kathodenfleck und dessen Rand Teile mitgerissen werden, die nicht von atomarer Grösse sind. Diese Konglomerate treffen als solche auf dem Substrat auf und resultieren in rauen Schichten, die in den Spritzern nicht voll durchreagiert werden können. Die Vermeidung bzw. Zerteilung dieser Spritzer ist bisher nicht gelungen, schon gar nicht für reaktive Beschichtungsprozesse. Bei diesen bildet sich auf der Kathode der Arcverdampferquelle, in beispielsweise Sauerstoffatmosphäre, zusätzlich. noch eine dünne Oxidschicht, die zu vermehrter Spritzerbildung neigt.

Die Aufgabe der vorliegenden Erfindung liegt darin die vorerwähnten Nachteile des Standes der Technik zu beseitigen. Insbesondere besteht die Aufgabe darin, Schichten mit besseren Eigenschaften wirtschaftlich abzuscheiden mit mindestens einer Arcverdampferquelle, derart, dass die Reaktivität beim Prozess durch bessere Ionisierung des verdampften Materials und des, beim Prozess beteiligten, Reaktivgases erhöht wird. Bei diesem reaktiven Prozess soll die Grösse und Häufigkeit der Spritzer wesentlich reduziert werden, insbesondere bei reaktiven Prozessen zur Herstellung isolierender Schichten. Weiter soll eine bessere Prozesskontrolle ermöglicht werden, wie die Kontrolle der Verdampfungsraten, Erhöhung der Schichtqualität, Einstellbarkeit der Schichteigenschaften, Verbesserung der Homogenität der Reaktion, sowie die Verminderung der Oberflächenrauhigkeit der abgeschiedenen Schicht. Diese Verbesserungen sind insbesondere auch von Bedeutung bei der Herstellung von gradierten Schichten und / oder Legierungen. Die Prozessstabilität bei reaktiven Prozessen zur Herstellung isolierender Schichten soll generell erhöht werden.

Insbesondere soll ein Arcverdampfungsprozess ermöglicht werden, der die wirtschaftliche Abscheidung von oxidischen Hartstoffschichten ermöglicht, Aluminiumoxid- und /oder A-luminiumchromoxidschichten welche vorzugsweise im wesentlichen Alpha und/oder Gammastruktur aufweisen.

Ausserdem soll ein Niedertemperaturprozess realisiert werden können, vorzugsweise unter 700°C, auch bei hoher Wirtschaftlichkeit des Verfahrens. Im Weiteren soll der Aufwand für die Vorrichtung und insbesondere für die Leistungsversorgung für den gepulsten Betrieb gering gehalten werden können. Die vorerwähnten Aufgaben können sowohl einzeln wie auch in ihrer Kombination abhängig vom jeweiligen, geforderten Einsatzbereich auftreten.

Die Aufgabe wird erfindungsgemäss durch eine mit einem Arc-Verdampfungs- PVD -Verfahren hergestellte Hartstoffschicht nach Anspruch 1 gelöst und durch Vorgehen nach einem Verfahren nach Anspruch 6 zur Herstellung einer solchen Schicht auf einem Werkstück. Anspruch 10 bezieht sich auf eine Vakuumbehandlungsanlage zur Abscheidung eines derartigen Schicht. Die abhängigen Ansprüche definieren weitere vorteilhafte Ausführungsformen.

Die Aufgabe wird erfindungsgemäss dadurch gelöst, dass eine Hartstoffschicht als Arc - PVD Funktionsschicht auf ein Werkstück abgeschieden wird, wobei diese Schicht im wesentlichen als elektrisch isolierendes Oxid ausgebildet ist, aus mindestens einem der Metalle (Me) Al, Cr, Fe, Ni, Co, Zr, Mo, Y, besteht und die Funktionsschicht einen Gehalt an Edelgasen und / oder Halogenen von weniger als 2% aufweist. Wobei der Gehalt an Edelgasen bevorzugt weniger als 0,1% insbesondere kleiner 0,05% oder noch besser null ist und / oder der Gehalt an Halogenen kleiner als 0,5%, insbesondere kleiner 0,1% oder noch besser null ist. Diese Gase sollen in möglichst geringem Ausmass in der Schicht eingebaut sein, und der Arcverdampfungsprozess daher ausschliesslich mit reinem Reaktivgas oder einer reinen Reaktivgasmischung ohne Edelgasanteil, wie He, Ne, Ar, oder Halogengasen, wie F₂, Cl₂, Br₂, J₂, bzw. halogenhaltigen Verbindungen wie CF₆ oder Ähnlichem erfolgen.

Die bekannten CVD - Prozesse verwenden Halogengase mit welchen bei unerwünscht hohen Temperaturen von etwa 1100°C eine Schicht abgeschieden wird. Die bekannten Sputterprozesse werden, auch bei Reaktivprozessbedingungen, mit einem hohen Anteil Edelgas, wie mit Argon, betrieben. Der Gehalt derartiger Gase in der Schicht sollte unter den vorerwähnten Werten liegen oder vorzugsweise null sein. Der erfindungsgemässe Puls- Arcverdampfungsprozess ermöglicht auch ohne derartige Prozessgase auszukommen.

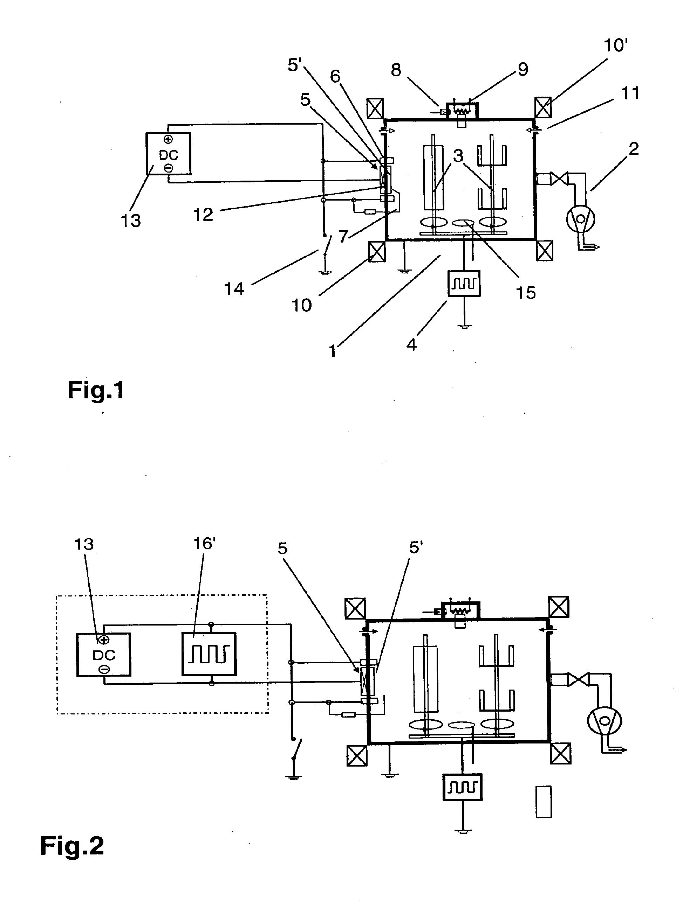

Die vorangehende Patentanmeldung mit Anmeldenummer CH 00518/05 zeigt im Wesentlichen für dieses Problem bereits einen Lösungsansatz auf. Es wird eine erste Lösung angegeben, die besonders gut für vollständig reagierte Targetoberflächen geeignet ist und eine deutliche Reduzierung der Spritzerbildung gegenüber DC- betriebenen Arcverdampfertargets aufweist. In dieser Anmeldung wird vorgeschlagen der DC- Speisung einer Arcverdampferquelle mit einer Pulsstromversorgung einen Hochstromimpuls zu überlagern, wie dies in der Figur 2 schematisch dargestellt ist.

Eine weitere Reduktion der Spritzer und ihrer Grösse bei höherer Wirtschaftlichkeit wird erreicht durch das Vorgehen gemäss der nachfolgenden Patentanmeldung CH 01289/05 welche Priorität auf die CH 00518/05 nimmt und eine Weiterentwicklung darstellt. In dieser Anmeldung ist eine Vakuumprozessanlage zur Oberflächenbearbeitung von Werkstücken mit mindestens einer Arcverdampferquelle vorgesehen, enthaltend eine erste Elektrode, welche mit einer DC - Stromversorgung verbunden ist, wobei zusätzlich eine, von der Arcverdampferquelle getrennt angeordnete, zweite Elektrode vorgesehen ist und dass die beiden Elektroden mit einer einzelnen Pulsstromversorgung verbunden sind. Zwischen den beiden Elektroden wird somit eine zusätzliche Entladungsstrecke betrieben mit nur einer einzelnen Pulsstromversorgung, welche eine besonders hohe Ionisation der beteiligten Materialien ermöglicht bei sehr guter Kontrollierbarkeit des Prozesses.

Die zweite Elektrode kann hierbei eine weitere Arcverdampferquelle sein, eine Werkstückhalterung bzw. das Werkstück selbst, wodurch die zweite Elektrode in diesem Fall als Bias Elektrode betrieben wird oder die zweite Elektrode kann auch als Verdampfungstiegel ausgebildet sein, welcher die Anode eines Niedervoltbogen - Verdampfers bildet.

Eine besonders bevorzugte Ausbildung besteht darin, dass beide Elektroden die Kathoden je einer Arcverdampferquelle sind und dass diese Arcverdampferquellen jede für sich direkt mit einer DC-Stromversorgung verbunden sind zur Aufrechterhaltung eines Haltestromes und wobei die beiden Kathoden mit einer einzelnen Pulsstromversorgung verbunden sind derart, dass die Arcs bzw. die Bogenentladungen der beiden Quellen im Betrieb nicht gelöscht werden. In dieser Konfiguration wird somit nur eine Pulsstromversorgung benötigt, da diese unmittelbar zwischen die beiden Kathoden der Arcverdampfer geschaltet ist. Neben dem hohen Ionisierungsgrad und der guten Kontrollierbarkeit des Prozesses stellt sich auch ein hoher Wirkungsgrad der Anordnung ein. Zwischen diesen beiden Elektroden und der dadurch zusätzlich erzeugten Puls - Entladungsstrecke bildet sich gegenüber dieser Entladungsstrecke elektrisch ein bipolarer Puls aus mit negativen und positiven Anteilen wodurch die ganze Periodendauer dieser eingespiesenen Wechselspannung für den Prozess genutzt werden kann. Tatsächlich entstehen keine ungenutzten Pulspausen und sowohl der negative wie auch der positive Puls leisten ohne Unterbruch insgesamt den Beitrag an den Prozess. Die Abscheiderate kann dadurch zusätzlich erhöht werden ohne zusätzliche teure Pulsstromversorgungen einsetzten zu müssen. Diese Anordnung, mit zwei Arcverdampferquellen, ist besonders geeignet zur Abscheidung von Schichten ab einem metallischen Target unter Verwendung von reaktivem Gas. Mit dieser Anordnung wird es sogar möglich gänzlich auf stützende Edelgase, wie Argon zu verzichten und es kann mit reinem Reaktivgas gearbeitet werden, sogar überraschenderweise mit reinem Sauerstoff. Durch den damit hohen erreichbaren Ionisierungsgrad, sowohl des verdampften Materials wie auch des Reaktivgases, wie beispielsweise Sauerstoff, werden nicht-leitende Schichten mit hoher Qualität erzeugt, die nahe an die Qualität des Bulk - Materials heranreichen. Der Prozess läuft hierbei sehr stabil und überraschenderweise wird hierbei auch noch die Spritzerbildung drastisch reduziert oder beinahe gänzlich vermieden. Die vorerwähnten Vorteile könne aber auch erzielt werden durch Verwendung von anderen Quellen als zweite Elektrode, wie beispielsweise eine Biaselektrode oder einen Niedervoltbogenverdampfertiegel, obwohl die erwähnten vorteilhaften Auswirkungen nicht in dem selben Mass erreicht werden wie bei der Ausbildung der Anordnung mit zwei Arcverdampfern.

Die vorliegende Anmeldung nimmt Priorität auf die beiden erwähnten vorangehenden Anmeldungen CH 00518/05 und 01289/05 welche im Wesentlichen für die vorliegende Aufgabenstellung der Abscheidung von elektrisch nicht-leitenden oxidischen Schichten einen ersten Lösungsansatz aufzeigen. Die in der vorliegenden Patentanmeldung vorgestellte Erfindung stellt eine Weiterentwicklung dar betreffend der Prozessführung und der Anwendung.

Die Erfindung wird im Nachfolgenden beispielsweise und schematisch mit Figuren näher erläutert. Es zeigen:
- Fig. 1: schematisch eine Darstellung einer Arcverdampfer Beschichtungsanlage, wie sie dem Stand der Technik entspricht;
- Fig. 2: eine erste Anordnung mit einer DC gespeisten Arcverdampferquelle bei Betrieb mit überlagertem Hochstrompuls;
- Fig. 3: eine zweite Anordnung mit zwei DC gespeisten Arcverdampferquellen und dazwischen geschalteter Hochstrompulsversorgung gemäss der Erfindung, eine Dual- Puls Arcverdampferanordnung;
- Fig. 4: ein Querschnitt durch eine abgeschiedene Schicht als Mehrfachschicht, gemäss der Erfindung;
- Fig. 5: ein vergrösserter Querschnitt der Schicht nach Figur 4.

In Fig. 1 ist eine Vakuumprozessanlage dargestellt, welche eine aus dem Stand der Technik bekannte Anordnung zeigt zum Betreiben einer Arcverdampferquelle 5 mit einer DC-Stromversorgung 13. Die Anlage 1 ist mit einem Pumpsystem 2 ausgerüstet zur Erstellung des notwendigen Vakuums in der Kammer der Vakuumprozessanlage 1. Das Pumpsystem 2 ermöglicht den Betrieb der Beschichtungsanlage bei Drucken < 10⁻¹ mbar und stellt auch den Betrieb sicher mit den typischen Reaktivgasen, wie O₂, N₂, SiH₄, Kohlenwasserstoffe, etc.. Die Reaktivgase werden über einen Gaseinlass 11 in die Kammer 1 eingelassen und dort entsprechend verteilt. Es ist zusätzlich möglich durch weitere Gaseinlasse zusätzliche Reaktivgase einzulassen oder aber auch Edelgase, wie Argon, wenn dies z. B. für Aetzprozesse oder für die Abscheidung nicht-reaktiver Schichten notwendig ist, um die Gase einzeln und/oder in Mischungen zu benutzen. Die in der Anlage angeordnete Werkstückhalterung 3 dient der Aufnahme und der elektrischen Kontaktierung der hier nicht mehr dargestellten Werkstücke, welche üblicherweise aus metallischen Materialien gefertigt sind, und zur Abscheidung von Hartstoffschichten mit derartigen Prozessen. Eine Bias - Stromversorgung 4 ist elektrisch mit der Werkstückhalterung 3 verbunden zur Anlegung einer Substratspannung bzw. einer Biasspannung an die Werkstücke. Die Bias - Stromversorgung 4 kann eine DC, eine AC oder eine bi- bzw. eine unipolare Puls - Substratstromversorgung sein. Über einen Prozessgaseinlass (11) kann ein Edel- bzw. ein Reaktivgas eingelassen werden, um Prozessdruck und Gaszusammensetzung in der Behandlungskammer vorzugeben und zu steuern.

Bestandteil der Arcverdampferquelle 5 sind ein Target 5' mit dahinter liegender Kühlplatte und einen Zündfinger 7, der im Peripheriebereich der Targetoberfläche angeordnet ist sowie eine das Target umschliessende Anode 6. Mit einem Schalter 14 ist es möglich zwischen einem floatenden Betrieb der Anode 6 des positiven Pols der Stromversorgung 13 und einem Betrieb mit definiertem Null- bzw. Massepotenzial zu wählen. Mit dem Zündfinger 7 wird bspw. beim Zünden des Lichtbogens der Arcverdampferquelle 5 ein kurzzeitiger Kontakt mit der Kathode hergestellt und dieser dann weggezogen, wodurch ein Funken gezündet wird. Der Zündfinger 7 ist hierzu bspw. Über einen Strombegrenzungswiderstand mit Anodenpotenzial verbunden.

Die Vakuumprozessanlage 1 kann zusätzlich fakultativ, wenn die Prozessführung es notwendig macht mit einer zusätzlichen Plasmaquelle 9 ausgerüstet werden. In diesem Fall ist die Plasmaquelle 9 als Quelle zur Erzeugung eines Niedervoltbogens mit Heisskathode ausgebildet. Die Heisskathode ist bspw. als Filament ausgebildet, welches in einer kleinen Ionisationskammer angeordnet ist, in welches mit einem Gaseinlass 8 ein Arbeitsgas, wie bspw. Argon eingelassen wird, zur Erzeugung einer Niedervoltbogenentladung, die sich in die Hauptkammer der Vakuumprozessanlage 1 erstreckt. Eine Anode 15 für die Ausbildung der Niedervoltbogenentladung ist in der Kammer der Vakuumprozessanlage 1 entsprechend positioniert angeordnet und wird auf bekannte Art und Weise mit einer DC-Stromversorgung zwischen Kathode und der Plasmaquelle 9 und der Anode 15 betrieben. Bei Bedarf können zusätzliche Spulen 10, 10' vorgesehen werden, wie bspw. helmholzartige Anordnungen, die um die Vakuumprozessanlage 1 gelegt werden, zur magnetischen Bündelung bzw. Führung des Niedervoltbogenplasmas.

Entsprechend vorgehen gemäss Erfindung wird, wie in Figur 2 dargestellt die Arcverdampferquelle 5 zusätzlich mit einer Puls-Hochstromversorgung 16' gespiesen, betrieben. Diese Pulsstromversorgung 16' wird mit Vorteil direkt der DC-Stromversorgung überlagert. Selbstverständlich müssen die beiden Versorgungen zu ihrem Schutz gegeneinander elektrisch entkoppelt betrieben werden. Dies kann auf übliche Art mit Filtern geschehen, wie mit Induktivitäten, wie dies dem Elektronikfachmann geläufig ist. Bereits mit dieser Anordnung ist es möglich entsprechend der Erfindung ausschliesslich mit reinem Reaktivgas oder Reaktivgasmischungen Schichten abzuscheiden, wie Oxide Nitride etc., ohne unerwünschte Stützgasanteile wie etwa Argon bei PVD-Sputterprozessen oder Halogene der Precursor bei CVD Prozessen Insbesondere ist es damit möglich die sehr schwierig wirtschaftlich zu erzielenden, elektrisch nicht leitenden, reinen Oxide in der gewünschten kristallinen Form zu erzeugen und als Schicht abzuscheiden. Dieses Reaktive Puls-Arcverdampfungsverfahren wird hiermit als RPAE Verfahren bezeichnet.

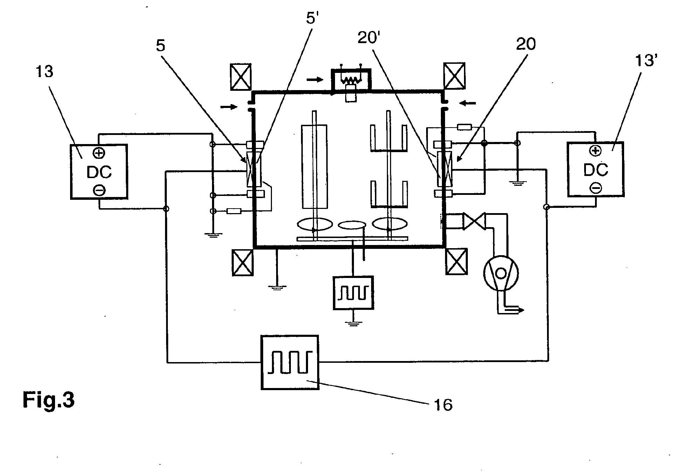

In einer weiteren verbesserten und bevorzugten erfinderischen Ausbildung einer Vakuumprozessanordnung wird nun neben einer ersten Arcverdampferquelle 5 mit der Targetelektrode 5' eine zweite Arcverdampferquelle 20 mit der zweiten Targetelektrode 20' vorgesehen, wie dies in Fig. 3 dargestellt ist. Beide Arcverdampferquellen 5, 20, werden mit je einer DC-Stromversorgung 13 und 13' betrieben, derart, dass die DC-Stromversorgungen mit einem Grundstrom die Aufrechterhaltung der Bogenentladung gewährleisten. Die DC-Stromversorgungen 13, 13' entsprechen dem heutigen Stand der Technik und können kostengünstig realisiert werden. Die beiden Elektroden 5', 20', welche die Kathoden der beiden Arcverdampferquellen 5, 20 bilden sind entsprechend der vorliegenden Erfindung mit einer einzelnen Pulsstromversorgung 16 verbunden, welche in der Lage ist, an die beiden Elektroden 5',20' hohe Pulsströme mit definierter Form und Flankensteilheit der Pulse abzugeben. In der dargestellten Anordnung nach Fig. 3 sind die Anoden 6 der beiden Arcverdampferquellen 5, 20 auf das elektrische Potenzial der Masse der Prozessanlage 1 bezogen. Dieses wird hiermit auch als Dual- Pulsed- Arcverdampfen (DPAE) bezeichnet.

Es ist möglich die Funkenentladungen Masse bezogen oder Masse frei zu betreiben. Im bevorzugten Masse freien Fall wird die erste DC-Stromversorgung 13 mit deren minus Pol mit der Kathode 5' der ersten Arcverdampferquelle 5 verbunden und deren positiver Pol mit der gegenüberliegenden Anode der zweiten Arcverdampferquelle 20 verbunden. Die zweite Arcverdampferquelle 20 wird analog betrieben und die zweite Stromversorgung 13' ist mit dem positiven Pol der Anode der ersten Arcverdampferquelle 5 verbunden. Dieser gegenüberliegende Betrieb der Anoden der Arcverdampferquellen führt zu einer besseren Ionisierung der Materialien im Prozess. Der Masse freie Betrieb, bzw. der floatende oder schwebende Betrieb der Arcverdampferquelle 5, 20 kann aber auch ohne Verwendung der gegenüberliegenden Anodeneinspeisung erfolgen. Ausserdem ist es möglich, einen Schalter 14 vorzusehen, wie in Figur 1 dargestellt, um wahlweise zwischen massefreien und massegebundenen Betrieb umschalten zu können.

Die Versorgung für diesen "Dual Pulsed Mode" muss verschiedene Impedanzbereiche überstreichen können und trotz allem noch "hart" in der Spannung sein. Das bedeutet, dass die Versorgung hohe Ströme liefern muss, aber dabei trotzdem weitgehend spannungsstabil betrieben werden kann. Ein Beispiel einer solchen Versorgung wurde parallel mit gleichem Datum zur vorerwähnten Patentanmeldung NR. CH 1289/05 mit der Nr. CH 518/05 angemeldet.

Der erste und bevorzugte Anwendungsbereich dieser Erfindung ist derjenige der kathodischen Funkenverdampfung mit zwei gepulsten Arcverdampferquellen (5, 20) wie es in Figur 3 dargestellt ist. Für diese Anwendungen liegen die Impedanzen im Intervall von etwa 0.01 Ω bis 1 Q. Es muss hier noch angemerkt werden, dass gewöhnlich die Impedanzen der Quellen, zwischen denen "dual gepulst" wird, unterschiedlich sind. Das kann daran liegen, dass diese aus verschiedenen Materialien bzw. Legierungen bestehen, dass das Magnetfeld der Quellen unterschiedlich ist oder dass der Materialabtrag der Quellen in einem unterschiedlichen Stadium ist. Der "Dual Pulsed Mode" erlaubt nun einen Abgleich über das Einstellen der Pulsbreite derart, dass beide Quellen den gleichen Strom ziehen. Als Folge führt das zu unterschiedlichen Spannungen an den Quellen. Natürlich kann die Versorgung auch asymmetrisch bezüglich des Stromes belastet werden, wenn es für die Prozessführung wünschenswert erscheint, was beispielsweise der Fall ist für gradierte Schichten unterschiedlicher Materialien. Die Spannungsstabilität einer Versorgung lässt sich immer schwieriger realisieren, je kleiner die Impedanz des jeweiligen Plasmas ist. Die Umschaltbarkeit bzw. die gesteuerte Nachführbarkeit einer Versorgung auf verschiedene Ausgangsimpedanzen ist deshalb von besonderem Vorteil, falls man den vollen Bereich ihrer Leistung ausnutzen möchte, also beispielsweise vom Bereich 500 V/100 A auf 50 V/1000 A oder wie es in der parallelen Anmeldung Nr. CH 518/05 realisiert wird.

Die Vorteile einer solchen dual gepulsten Kathodenanordnung und insbesondere bestehend aus zwei Arcverdampferquellen sind zusammengefasst folgende:
1. Erhöhte Elektronenemission bei steilen Pulsen resultiert in höherem Strom (auch Substratstrom) und erhöhten Ionisierung des verdampften Materials und des Reaktivgases;
2. Die erhöhte Elektronendichte trägt auch zu einer schnelleren Entladung der Substratoberfläche bei, bei der Herstellung isolierender Schichten d.h. relativ kleine Umladezeiten am Substrat (oder auch nur Pulspausen der Biasspannung) sind ausreichend, um die sich bildenden isolierende Schichten zu entladen;
3. Der bipolare Betrieb zwischen den beiden kathodischen Arcverdampferquellen erlaubt einen quasi 100%iges PulsPausenverhältnis (duty cycle), während das Pulsen einer Quelle allein notwendigerweise immer eine Pause benötigt und deshalb die Effizienz nicht so hoch ist;
4. Der dual gepulste Betrieb zweier kathodischen Funkenquellen, die einander gegenüberliegen, taucht den Substratbereich in dichtes Plasma ein und erhöht die Reaktivität in diesem Bereich, auch vom Reaktivgas. Das zeigt sich auch an der Erhöhung des Substratstromes;
5. Bei reaktiven Prozessen in Sauerstoffatmösphäre können im gepulsten Betrieb noch höhere Elektronenemissionswerte erreicht werden und es scheint, dass sich ein Aufschmelzen des Funkenbereiches wie es bei der klassischen Verdampfung von metallischen Targets der Fall ist, weitgehend vermeiden lässt. Das Arbeiten in rein oxidischem reaktiven Mode ohne weitere Fremd- oder Stützgase ist nun ohne weiteres möglich.

Um die erwähnten vorteilhaften Prozesseigenschaften erzielen zu können bei den vorerwähnten verschiedenen möglichen Ausbildungsformen der Erfindung, muss die Pulsstromversorgung 16, 16' verschiedene Bedingungen erfüllen. Bei bipolarer Pulsdarstellung soll der Prozess bei einer Frequenz betrieben werden können, die im Bereich von 10Hz bis 500kHz liegt. Wegen der Ioniserungsverhältnisse ist hierbei die einhaltbare Flankensteilheit der Pulse wichtig. Sowohl die Beträge der ansteigenden Flanken U2/(t2-t1), U1/(t6-t5), wie auch der absteigenden Flanken U2/(t4-t3) und U1/(t8-t7) sollten Steilheiten aufweisen im Bereich von 0,02V/ns bis 2V/ns und dies zumindest im Leerlaufbetrieb also ohne Belastung, vorzugsweise aber auch bei Belastung. Selbstverständlich wirkt sich die Flankensteilheit beim Betrieb aus, je nach entsprechender Höhe der Belastung bzw. der anliegenden Impedanz oder der entsprechend Einstellungen. Die Pulsbreiten bei bipolarer Darstellung sind für t4 bis t1 und t8 bis t5 mit Vorteil ≥ 1us, wobei die Pausen t5 bis t4 und t9 bis t8 mit Vorteil im Wesentlichen 0 sein können, aber unter gewissen Voraussetzungen auch ≥ 0µs sein können. Wenn die Pulspausen > 0 sind, wird dieser Betrieb als lückend bezeichnet und es kann durch bspw. variable zeitverschiebung der Pulslückenbreiten der gezielte Eintrag von Energie in ein Plasma und dessen Stabilisierung eingestellt werden. Es ist besonders vorteilhaft, wenn die Pulsstromversorgung derart ausgelegt wird, dass ein Pulsbetrieb bis 500A bei 1000V Spannung möglich ist, wobei hierbei das Pulspausenverhältnis (duty cycle) entsprechend berücksichtigt, bzw. angepasst werden muss für die ausgelegte möglich Leistung der Versorgung. Neben der Flankensteilheit der Pulsspannung ist bevorzugt darauf zu achten, dass die Pulsstromversorgung (16) in der Lage ist einen Stromanstieg auf 500A in mind. 1µs zu bewältigen.

Mit dem hier vorgestellten Betrieb von Arcverdampferquellen mit DC - Speisung und überlagerter Hochstrompulsspeisung (RPAE, DPAE) ist es möglich hochqualitativ ab einem oder mehreren Metalltargets mit Reaktivgasathmosphäre entsprechende Metallverbindungen auf ein Werkstück 30 abzuscheiden. Dies ist insbesondere für die Erzeugung von rein oxidischen Schichten geeignet, da das Verfahren keine zusätzlichen Stützgase wie Edelgase, üblicherweise Argon, benötigt. Die Plasmaentladung des Arcverdampfers 5, 20 kann somit beispielsweise und bevorzugt in reiner Sauerstoffathmosphäre bei gewünschtem Arbeitsdruck erfolgen ohne, dass die Entladung instabil ist, verhindert wird, oder unbrauchbare Ergebnisse liefert, wie zu starke Spritzerbildung oder schlechte Schichteigenschaften. Es ist auch nicht notwendig, wie bei CVD Verfahren Halogenverbindungen einsetzen zu müssen Dies ermöglicht erst verschleissfeste oxidische Hartstoffschichten mit hoher Qualität, wirtschaftlich herzustellen bei tiefen Prozesstemperaturen, vorzugsweise unter 500°C, die im Ergebnis trotzdem hochtemperaturfest sind, bevorzugt >800°C und die chemisch sehr beständig sind, wie beispielsweise hohe Oxidationsbeständigkeit. Ausserdem soll zur Erreichung eines stabilen Schichtsystems die Diffusion von Sauerstoff mit der damit verbundenen Oxidation im tiefer liegenden Schichtsystem und / oder am Werkstück möglichst vermieden werden.

Es können nun ohne weiteres oxidische Schichten hergestellt werden in reinem Sauerstoff als Reaktivgas aus den Übergangsmetallen der Nebengruppen IV, V, VI des Periodensystems und Al, Si, Fe, Co, Ni, Y, wobei Al, Cr, Mo, Zr sowie Fe, Co, Ni, Y bevorzugt sind. Die Funktionsschicht 32 soll als Oxid eines oder mehrere dieser Metalle kein Edelgas und /oder Halogen, wie Cl enthalten aber zumindest weniger als 0,1% oder besser weniger als 0,05% Edelgas und weniger als 0,5% oder besser weniger als 0,1% Halogen, um die gewünschte Schichtqualität zu erzielen.

Derartige Funktionsschichten 32 oder Mehrfachschichtsystem 33 (Multilayer) sollen insbesondere als Hartstoffschicht eine Dicke im Bereich von 0,5 bis 12 µm aufweisen, bevorzugt von 1,0 bis 5,0 µm. Die Funktionsschicht kann direkt auf das Werkstück 30 abgeschieden werden welches ein Werkzeug, ein Maschinenbauteil, bevorzugt ein Schneidwerkzeug wie eine Wendeschneidplatte ist. Zwischen dieser Schicht und dem Werkstück 30 ist eine Zwischenschicht 31 angeordnet, die insbesondere eine Haftschicht bildet und vorzugsweise eines der Metalle der Nebengruppen IVa, Va und VIa des Periodensystems enthält und / oder Al oder SI enthält oder eine Mischung von diesen. Gute Hafteigenschaften werden mit Verbindungen dieser Metalle erreicht mit N, C, O, B, oder Mischungen davon, wobei die Verbindung die N enthält bevorzugt wird. Die Schichtdicke der Zwischenschicht 31 soll im Bereich von 0,05 bis 5µm liegen, vorzugsweise 0,1 bis 0,5µm. Mindestens eine der Funktionschichten 32 und / oder der Zwischenschicht 31 können mit Vorteil als Verlaufschicht 34 ausgebildet werden, wodurch ein besserer Übergang der Eigenschaften der jeweiligen Schichten bewirkt wird. Der Verlauf kann von metallisch über nitridisch, zu nitrooxidisch und bis zum reinen Oxid gehen. Es wird also ein Verlaufbereich 34 ausgebildet wo die Materialien der aneinander anstossenden Schichten, oder wenn keine Zwischenschicht vorhanden ist das Werkstückmaterial, ineinander vermischt werden.

Auf der Funktionsschicht 32 kann eine weitere Schicht oder ein Schichtsystem 35 als Deckschicht abgeschieden werden wenn dies erforderlich ist. Eine Deckschichten 35 kann als zusätzliche Reibminderungsschicht abgeschieden werden zur weiteren Verbesserung des tribologischen Verhaltens des beschichteten Werkstückes 30.

Es können, je nach Erfordernisse eine oder mehre Schichten der vorerwähnten Schichten oder Schichtsysteme im Bereich wo sie sich angrenzen als Verlaufschichten 34 ausgebildet werden oder innerhalb einzelner Schichten Konzentrationsgradient beliebiger Art erzeugt werden. Bei der vorliegenden Erfindung ist dies einfach möglich durch gesteuertes Einlassen der Reaktivgase in die Vakuumprozessanlage 1 zur Einstellung der jeweils dafür notwendigen Gasarten und der Gasmengen für den reaktiven Arc- Plasmaprozess.

Es können nun auch ohne weiteres mit den gewünschten Hartstoffeigenschaften als Funktionsschicht 32 Aluminiumoxid-schichten (Al₂O₃) Schichten hergestellt werden, die sogar im Wesentlichen stöchiometrische Zusammensetzung aufweisen. Besonders vorteilhafte Hartstoffschichten als. Funktionsschicht 32 bestehen im wesentlichen aus einer Aluminium-Metall (Me) Mischoxidschicht von der Form (AlₓMe₁₋ₓ)_{y}O_{z}, wobei Me vorzugsweise eines der Metalle Cr, Fe, Ni, Co, Zr, Mo, Y ist einzeln oder auch in Mischungen, einstellbar je nach gewünschten Anteilen x, y, und z der beteiligten Stoffe. Weiter besonders bevorzugt wird Chrom als Metall Me im Metall- Mischoxid des (AlₓMe₁₋ₓ))_{y}O_{z} welches somit die Form (AlₓCr₁₋ₓ)_{y}O_{z} oder (AlCr)_{y}O_{z} bildet. Hierbei sollte der Anteil 1-x des Metalles Chrom in der Schicht 5 bis 80 At% aufweisen, vorzugsweise 10 bis 60At% (Atom %).

Sehr geeignet als Hartstoff - Funktionsschicht 32 ist auch ein Metallnitrid, insbesondere das Aluminium Chrom Nitrid (AlCr)_{y}N_{z}, oder allenfalls auch (AlTi)_{y}N_{z}.

Durch die gezielte Möglichkeit der Prozessführung ist es nun auch möglich bei Aluminium- und Aluminium- Chromoxiden die besonders erwünschte Alpha und /oder Gammastruktur erzielen zu können.

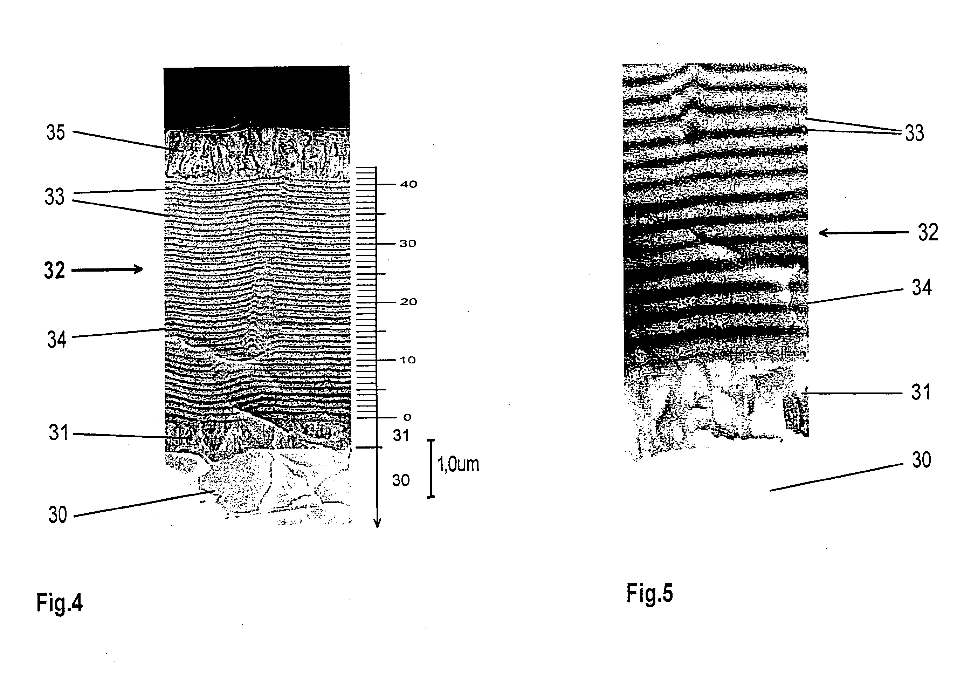

Wegen der vorerwähnten einfachen Einstellbarkeit der Schichtbedingungen mit ihrer Zusammensetzung über die Steuerung der Zuführung der Reaktivgase und wegen der stabilen Prozessführung, ist es erstmals möglich Mehrfachschichtsysteme (Multilayer) 33 mit beliebig vielen Lagen und beliebiger Zusammensetzung und sogar mit Verläufen herstellen zu können. Hierbei können mehrere Lagen aus verschiedenen Materialien oder was oft vorteilhaft ist mit den abwechselnd gleichen Materialien als eine Art Sandwich erzeugt werden. Für Hartstoff Funktionsschichten 32, ist ein Schichtsystem mit wiederholenden Schichtfolgepaaren 33, bei welchem sich die Materialzusammensetzung periodisch ändert, vorteilhaft. Vor allem ein Aufbau von Me₁ zu einem Me₂- Oxid und/oder von einem Me₁- Nitrid zu einem Me₁- Oxid und/öder von einem Me₁- Nitrid zu einem Me₂- Oxid bringt ausgezeichnete Ergebnisse bezüglich Standzeit und weniger Rissbildung der Funktionsschicht bzw. dieses Schichtsystems. Ein Beispiel einer Funktionsschicht 32 als Mehrfachschicht 33 ist in Figur 4 dargestellt und in vergrössertem Querschnitt in Figur 5. Dargestellt ist eine bevorzugte Materialpaarung von abwechselnd Aluminiumchromnitrid (AlCr)ₓN_{y} mit Aluminiumchromoxid (AlCr)ₓO_{y} hergestellt mit dem erfindungsgemässen Verfahren, vorzugsweise in stöchiometrischer Materialzusammensetzung. Das Schichtpaket enthält in diesem Beispiel 42 Schichtpaare mit abwechselnden Materialien, wie vorerwähnt. Die gesamte Schichtdicke dieser Funktionsschicht 32, als Mehrfachschichtsystem 33 beträgt etwa 4,1 µm, wobei somit die Dicke eines Schichtpaares, also zwei Lagen, 98nm betragen. Weitere bevorzugte Materialpaarungen sind abwechselnd Aluminiumzirkonnitrid (AlZr)ₓN_{y} mit Aluminiumzirkonoxid (AlZr)ₓO_{y} hergestellt mit dem erfindungsgemässen Verfahren, vorzugsweise in stöchiometrischer Materialzusammensetzung. Für Hartstoffschichten als Funktionsschicht 32 ist es von Vorteil wenn das Mehrfachschichtsystem 33 mindestens 20 Lagen aufweist, bevorzugt bis 500 Lagen. Hierbei sollte die Dicke pro Lage im Bereich von 0,01 bis 0,5 µm liegen, vorzugsweise im Bereich von 0,2 bis 0,1 µm. Im Bereich der einzelnen angrenzenden Lagen der Schichten sind auch Verläufe 34 ersichtlich die für gutes Verhalten der Übergänge sorgen.

Im Beispiel nach Figur 4 ist als Beispiel auch eine Deckschicht 35 als Reibminderungsschicht über der Funktionsschicht 32, 33 abgeschieden. Die Deckschicht besteht aus Titannitrid und ist etwa 0,83 µm dick.

Unterhalb der Funktionsschicht ist als Beispiel zusätzlich eine Zwischenschicht 31 als Haftschicht angeordnet welche etwa 1,31 µm dick ist und als Al-Cr-N Zwischenschicht mit RPAE auf das Werkstück 30 abgeschieden wurde.

Die hier vorgestellten Beschichtungen, ob Einfachschicht oder Mehrfachschichtsystem sollen bevorzugt einen R_{z} - Wert von nicht weniger als 1µm und/oder einen Rₐ - Wert von nicht weniger als 0,2µm aufweisen. Diese Werte sind jeweils direkt an der Oberfläche vor einer möglichen Nachbehandlung der Oberfläche, wie bürsten, strahlen, polieren etc. gemessen. Somit stellen die Werte eine rein prozessbedingte Oberflächenrauhigkeit dar. Unter Rₐ wird der Mittenrauhwert nach DIN 4768 verstanden. Dies ist der arithmetische Mittelwert aller Abweichungen des Rauhheitsprofiles R von der Mittellinie innerhalb der Gesamtmessstrecke 1ₘ. Unter R_{z} wird die gemittelte Rauhtiefe nach DIN 4768 verstanden. Dies ist der Mittelwert aus den Einzelrauhtiefen fünf aufeinander folgender Einzelmessstrecken 1ₑ im Rauheitsprofil. R_{z} hängt nur vom Abstand der höchsten Spitzen zu den tiefsten Tälern ab. Durch Mittelwertbildung wird der Einfluss einer einzelnen Spitze (Tales) gemindert und die mittlere Breite des Bandes, in dem das R-Profil eingeschlossen ist, berechnet.

Die vorgestellte Beschichtung, gemäss Erfindung, eignet sich besonders für Werkstücke, die Schneid-, Umform-, Spritzguss- oder Stanzwerkzeuge sind, ganz speziell aber für wendeschneidplatten.

Im folgendem wird ein typischer Ablauf einer Substratbehandlung in einem reaktiven Puls- Arcverdampfungsbeschichtungsprozess geschildert, unter Verwendung der vorliegenden Erfindung. Es wird neben dem eigentlichen Beschichtungsprozess, in dem die Erfindung realisiert wird, auch auf die anderen Prozessschritte eingegangen, die die Vor- und Nachbehandlung der Werkstücke betreffen. Alle diese Schritte lassen breite Variationen zu, einige können unter bestimmten Bedingungen auch weggelassen, verkürzt oder verlängert oder anders kombiniert werden.

In einem ersten Schritt werden die Werkstücke gewöhnlich einer nasschemischen Reinigung unterzogen, die je nach Material und Vorgeschichte verschieden durchgeführt wird.

### Beispiel 1:

Beschreibung eines typischen Prozessablaufes zur Herstellung einer Al-Cr-O-Schicht 32, (sowie eines AL-Cr-N/Al-Cr-O-Multilayer 33) und Al-Cr-N Zwischenschicht 31 mittels RPAE (Reaktiv-Puls-Arcverdampfen) zur Beschichtung von Werkstücken 30, wie Schneidewerkzeugen, vorzugsweise Wendeschneidplatten.
1. Vorbehandlung (Reinigung etc.) der Werkstücke (30) (Substrate) wie dem Fachmann bekannt.
2. Einlegen der Substrate in die dafür vorgesehenen Halterungen und Einbringen in das Beschichtungssystem
3. Abpumpen der Beschichtungskammer 1 auf einem Druck von ca. 10⁻⁴ mbar mittels eines Pumpsystems wie es dem Fachmann bekannt ist (Vorpumpen/Diffusionspumpe, Vorpumpen/Turbomolekularpumpe, Enddruck ca. 10⁻⁷ mbar erreichbar)
4. Starten der Substratvorbehandlung im Vakuum mit einem Heizschritt in einem Argon-Wasserstoffplasma oder einer anderen bekannten Plasmabehandlung. Ohne Einschränkung kann diese Vorbehandlung mit folgenden Parametern durchgeführt werden:
   Plasma einer Niedervoltbogenentladung mit ca. 100 A Entladestrom, bis 200 A, bis 400 A, bevorzugt werden die Substrate als Anode für diese Niedervoltbogenentladung geschaltet.
   Argonfluss 50 sccm
   Wasserstofffluss 300 sccm
   Substrattemperatur 500°C (teils durch Plasmaheizung, teils durch Strahlungsheizung)
   Prozesszeit 45 min
      Bevorzugt wird während dieses Schrittes eine Versorgung zwischen Substrate 30 und Masse oder einem anderen Bezugspotential gelegt, mit der die Substrate sowohl mit DC (bevorzugt positiv) oder DC gepulst (unipolar, bipolar) oder als MF (Mittelfrequenz) oder RF (Hochfrequenz) beaufschlagt werden können.
5. Als nächster Prozessschritt wird das Aetzen gestartet. Dafür wird der Niedervoltbogen zwischen dem Filament und der Hilfsanode betrieben. Eine DC, gepulste DC, MF oder RF Versorgung wird zwischen Substraten und Masse geschaltet und die Substrate bevorzugt mit negativer Spannung beaufschlagt. Bei den gepulsten und MF, RF Versorgungen wird auch positive Spannung an die Substrate gelegt. Die Versorgungen 4 können unipolar oder bipolar betrieben werden. Die typischen, aber nicht ausschliesslichen Prozessparameter während dieses Schrittes sind:
   Argonfluss 60 sccm
   Entladestrom Niedervoltbogen 150 A
   Substrattemperatur 500°C (teils durch Plasmaheizung, teils durch Strahlungsheizung)
   Prozesszeit 30 min

   Um die Stabilität der Niedervoltbogenentladung bei der Herstellung isolierender Schichten zu gewährleisten, wird entweder mit heisser, leitfähiger Hilfsanode 15 gearbeitet oder eine gepulste Hochstromversorgung zwischen Hilfsanode und Masse geschaltet.
6. Beginn der Beschichtung mit der Zwischenschicht 31 (ca. 15 min)
   CrN Zwischenschicht 300 nm mittels Funkenverdampfung (Quellenstrom 140 A, Ar 80 sccm, N2 1200 sccm, mit Bias von -80V oder von -100V runter auf -60V bzw. 40V.
   Die Beschichtung kann mit und ohne Niedervoltbogen erfolgen.
7. Uebergang zur Funktionsschicht 32 (ca. 5 min)
   Im Uebergang zur eigentlichen Funktionsschicht werden die Funkenquellen zusätzlich mit unipolaren DC Pulsen einer zweiten Stromversorgung parallel geschaltet überlagert, die mit 50 kHz betrieben werden kann (Fig.2). Zusätzlich wird ein Al-Target auf die gleiche Weise betrieben, um AlCr als Schicht herzustellen. Im Beispiel wurde mit 10µs Puls/10 µs Pause gearbeitet und in den Pulsen Ströme bis 150A generiert. Dann erfolgt der Einlass des Sauerstoffs von 200 sccm.
8. Zurückfahren der AlCrN Beschichtung
   Nachdem sich der Sauerstoffgasfluss stabilisiert hat, erfolgt das Herunterfahren der AlCrN Beschichtung. Dafür wird der N2 Gasfluss reduziert. Diese Rampe erfolgt über ca. 10 min. Anschliessend wird der Ar Fluss auf Null gefahren (falls nicht mit Niedervoltbogen gearbeitet wird).
9. Beschichten mit der Funktionsschicht 32
   Die Beschichtung der Substrate mit der eigentlichen Funktionsschicht erfolgt im reinen Reaktivgas (in dem Fall Sauerstoff). Die wichtigsten Prozessparameter sind:
   Sauerstofffluss 400 sccm
   Substrattemperatur 500°C
   DC Quellenstrom 60A

Dem DC Quellenstrom wird ein gepulster DC Strom (unipolar) von 150A überlagert mit einer Pulsfrequenz von 50 kHz und einer Pulscharakteristik von 10µs Puls/10 µs Pause. Prozessdruck in der Beschichtungskammer 9x10⁻³ mbar. Der Bias an den Substraten wird auf -40V zurückgefahren. Da es sich bei Aluminiumoxid um isolierende Schichten handelt, wird eine Biasversorgung verwendet, die entweder DC gepulst oder als MF (50 kHz - 350 kHz) betrieben wird.

Die Beschichtung kann auch simultan mit dem Niedervoltbogen erfolgen. In diesem Falle wird eine höhere Reaktivität erzielt. Ausserdem hat die simultane Benutzung des Niedervoltbogens während der Beschichtung auch noch den Vorteil, dass der DC Anteil bei den Quellen reduziert werden kann. Mit höherem Bogenstrom, kann dieser weiter reduziert werden.

Der so geführte Beschichtungsprozess ist stabil auch über mehrere Stunden. Das Target 5, 5' bedeckt sich mit einer dünnen, glatten Oxidschicht. Es entstehen aber keine isolierenden Inseln, obwohl sich die Targetoberfläche durch den Sauerstoff ändert, was sich auch in der Erhöhung der Brennspannung äussert. Die Targetoberfläche bleibt wesentlich glatter. Der Funken läuft ruhiger und teilt sich in mehrere kleinere Funken auf. Die Spritzerzahl wird wesentlich reduziert.

Der beschriebene Prozess ist eine grundlegende bevorzugte Version, da er die Anforderungen an die gepulste Stromversorgung gering hält. Die DC-Versorgung liefert den Mindest- oder Haltestrom für den Funken und die gepulste Hochstromversorgung 16, 16' dient zur Vermeidung der Spritzer und stellt den Prozess sicher.

Eine Möglichkeit, um Multilayersysteme 33, also Mehrfachschichten 33 für das obige Schichtbeispiel zu erzeugen, besteht nun darin, dass man den Sauerstofffluss während der Schichtabscheidung verringert oder ganz abschaltet, während man den Stickstofffuss zuschaltet. Das kann sowohl periodisch wie aperiodisch, mit Schichten ausschliesslicher oder gemischter Sauerstoff-Stickstoffkonzentration erfolgen. Auf diese Weise werden Multilayer 33 hergestellt wie sie in Figur 4 und vergrössert in Figur 5, beispielhaft im Querschnitt dargestellt sind. In vielen Fällen schliesst diese Funktionsschicht 32 die Beschichtung nach aussen ab, ohne dass eine weitere Schicht darauf folgt.

Verschleisseigenschaften können je nach Anwendung und bedarf mit einer oder mehreren Deckschichten 35 "getopt" werden. Das Beispiel des bereits oben beschriebenen AlCrN/AlCrO- Multilayers mit einer TiN Topschicht ist ebenfalls in Figur 4 gezeigt. Die mindestens eine Deckschicht 35 kann in diesem Fall beispielsweise eine Reibminderungsschicht sein, wobei dann die Hartstoffschicht 32, bzw. die Funktionsschicht oder die Mehrfachschicht als Stützschicht für die Reibminderungsschicht 35 dient.

Besteht der Wunsch, Multilayer-Funktionsschichten 33 oder Multilayer-Zwischenschichten mit besonders dünnen oxidhaltigen Schichtdicken herzustellen, so kann das in einer bevorzugten Prozessvariante auch dadurch erfolgen, dass der Betrieb der oxidbildenden Targets unter Sauerstofffluss gerade solange erfolgt, bis das Target erste Vergiftungserscheinungen zeigt (Spannungsanstieg, meist nach wenigen Minuten) und dann jeweils wieder auf beispielsweise Stickstofffluss umgeschaltet wird. Diese Prozessvariante ist besonders einfach und kann mit dem existierenden Stand der Technik (Fig.1), also ohne Target-Puls-Betrieb realisiert werden. Dies erlaubt dann aber nicht ein freies Anpassen der Schichtdicken an die jeweiligen Anforderungen.

Die Ausführung des vorerwähnten Beispiels im Dual-Puls-Betrieb mit zwei oder mehr Arcverdampferquellen bringt zusätzliche Vorteile in Bezug auf Prozessführung und Wirtschaftlichkeit.

### Beispiel 2:

Beschichtung von Werkstücken 30, wie Schneidwerkzeugen, vorzugsweise Wendeschneidplatten, mit einem Al-Cr-O-Hartstoffschichtsystem 32 und Cr-N-Zwischenschicht 31 mittels DPAE (Dual-Puls-Arcverdampfer)

Schritte 1 bis einschliesslich 5 analog Beispiel 1.
6. Beginn der Beschichtung mit der Zwischenschicht (ca. 15 min)
   AlCrN Zwischenschicht 300 nm mittels Funkenverdampfung (Targetmaterial AlCr (50%, 50%), Quellenstrom 180 A, N2 800 sccm, mit bipolar Bias von -180V (36 µs negativ, 4 µs positiv).
   Die Beschichtung kann mit und ohne Niedervoltbogen erfolgen.
   Bis zu diesem Punkt folgt das Verfahren dem Stand der Technik wie er beispielhaft in Abbildung 1 wiedergegeben ist.
7. Uebergang zur Funktionsschicht 32 (ca. 5 min)
   Im Uebergang zur eigentlichen Funktionsschicht 32 wird der Stickstoff von 800 sccm auf ca. 600 sccm heruntergerampt und anschliessend ein Sauerstofffluss von 400 sccm eingeschaltet. Der Stickstofffluss wird nun ausgeschaltet.
8. Beschichten mit der Funktionsschicht 32
   Nun wird die bipolar gepulste Hochstromversorgung 16, wie in Abbildung 3 gezeigt, zwischen beiden Arcverdampferkathoden 5, 20 in Betrieb genommen. Im beschriebenen Prozess wurde mit einem zeitlichen positiven bzw. negativen Mittelwert des Stromes von ca. 50 A gearbeitet. Die Pulsdauern betragen jeweils 10 µs für den positiven wie negativen Spannungsbereich mit jeweils 10 µs Pause dazwischen bei einer Spannung von 160 V. Der Spitzenwert des Stroms durch die bipolar gepulste Stromversorgung 16 hängt von der jeweiligen Pulsform ab. Die Differenz aus DC Strom durch die jeweilige Arcverdampferkathode 5, 20 und Spitzenwert des bipolar gepulsten Stromes darf den sog. Haltestrom der Arcverdampferkathode 5, 20 nicht unterschreiten, da sonst der Arc (Funken) verlöscht.
   Während der ersten 10 Minuten der Beschichtung wird der Bias von -180 V auf -60 V gerampt. Die typischen Beschichtungsraten für doppelt rotierende Werkstücke 30 liegen zwischen 3 µm/h und 6 µm/h.
   Die Beschichtung der Werkstücke 30 mit der eigentlichen Funktionsschicht 32 erfolgt also in reinem Reaktivgas (in diesem Beispiel Fall Sauerstoff). Die wichtigsten Prozesseparameter sind noch einmal zusammengefasst:
   Sauerstofffluss 400 sccm
   Werkstücktemperatur 500°C
   DC Quellenstrom 180 A, sowohl für die Al- wie auch für die Cr-Quelle.

   Der bipolar gepulste DC Strom zwischen den beiden Kathoden hat eine Frequenz von 25 kHz.
   Prozessdruck ca. 9x10⁻³ mbar

Wie schon erwähnt, kann die Beschichtung auch simultan mit dem Betrieb des Niedervoltbogen erfolgen. In diesem Falle wird eine weitere Erhöhung der Reaktivität vor allem in Werkstücknähe erzielt. Ausserdem hat die simultane Benutzung des Niedervoltbogens während der Beschichtung auch noch den Vorteil, dass der DC Anteil bei den Quellen reduziert werden kann. Mit höherem Bogenstrom, kann dieser weiter reduziert werden.

Der so geführte Beschichtungsprozess ist stabil auch über mehrere Stunden. Die Targets 5', 20' der Arcverdampfer 5, 20 bedecken sich mit einer dünnen, glatten Oxidschicht. Dies ist erwünscht und auch Voraussetzung für einen weitgehend spritzerfreien und stabilen Prozess. Die Bedeckung manifestiert sich in einer Erhöhung der Spannung am Target.

Es wurden Werkstücke mit verschiedenen Beschichtungen beschichtet und unter den selben Bedingen einem praktischen Vergleichstest unterworfen.

### Testbedingungen für die Drehtests:

Als Mass für diese Tests wurden bekannte TiAlN-Schichten und bekannte, mittels CVD abgeschiedene alpha-Aluminiumoxid-Schichten herangezogen. Bei allen Testschichten wurde eine Schichtdicke von 4 µm untersucht. Als Testmaterial wurde rostfreier Stahl (1.1192) benutzt. Als Drehzyklus wurden jeweils 1, 2 und 4 min gewählt. Die Schnittgeschwindigkeit betrug 350 m/min, Vorschub 0.3 mm/rev, Eingrifftiefe 2 mm. Die Bedingungen wurde derart gewählt, dass kurze Testzeiten erzielbar sind bei hohen Temperaturen an der Schneidkante des Werkstückes.

Es wurde der Verschleiss an der Frei- und Spanfläche sowie die Oberflächenrauhigkeit des bearbeiteten Stahls untersucht, und die Zeitdauer ermittelt, bis es zu einer bestimmten erhöhten Rauhigkeit kam. Als quantitatives Mass für den Verschleiss wurde diese Standzeit ermittelt

### Resultate:

### a) CVD-Schicht alpha-Aluminiumoxid (Stand der Technik), Schichtdicke d= 4µm.

Das Werkzeug überlebte den 4 Minuten-Test. Im SEM war jedoch nach dem Test kein Schichtmaterial mehr auf der Spanfläche.

### b) TiAlN-Schicht (Stand der Technik), d=4 µm

Diese Schicht zeigte schon nach weniger als 2 min erste Zerstörungen und lieferte eine rauhe Oberfläche am Werkstück.

### Erfindung:

c) AlCrN-Zwischenschicht, d= 0.4µm
   AlCrN/AlCrO-Multilayer, d= 3.6µm
   TiN-Topschicht, d= 0.8µm
   Standzeit 4 min
d) AlCrN-Zwischenschicht, d= 0.4 µm
   AlCrN/AlCrO-Multilayer, d= 3.6 µm
   3min 40 s
e) AlCrN-Zwischenschicht, d= 0.3 µm
   AlCrO-Einzellayer, d= 2.9 µm
   TiN-Topschicht, d= 0.9 µm
   4 min
f) AlCrN-Zwischenschicht, d= 0.35 µm
   AlCrO-Einzellayer, d= 3.5 µm
   3 min 20s
g) ZrN-Zwischenschicht, d= 0.3 µm
   ZrN/AlCrO-Multilayer, d= 3.8 µm
   ZrN-Topschicht, d= 0.5 µm
   3 min 10 s
h) ZrN-Zwischenschicht, d= 0.2 µm
   ZrO/AlCrO-Multilayer, d= 6.4 µm
   ZrN-Topschicht, d= 0.8 µm
   4 min
i) AlCrN-Zwischenschicht, d= 0.5 µm
   AlCrO/alpha alumina-Multilayer, d= 8.2 µm
   4 min
k) (Ti,AlCrN)-Zwischenschicht, d= 0.4 µm
   AlCrO/TiAlCrN-Multilayer, d= 4.5 µm
   3 min 50 s

Schichten aus bzw. Multilayer enthaltend oxidische Schichten aus den angegebenen Materialien zeigen deutlich weniger Verschleiss bei hohen Schnittgeschwindigkeiten. Leitende Schichten (TiAlN), gemäss Stand der Technik, sind bei hohen Schnittgeschwindigkeiten den erfindungsgemässen Oxidsystemen betreffs Verschleiss deutlich unterlegen. Systeme gemäss vorliegender Erfindung aus (AlCr)_{y}O_{z} und (AlZr)_{y}O_{z} zeigen ähnlich geringen Verschleiss wie bekannte CVD-Schichten aus α-Aluminiumoxid, aber ohne deren Nachteil einer hohen Temperaturbelastung bzw. Belastung durch aggressive Chemikalien des Werkstücks während des Beschichtungsprozesses. Weiters kann die Prozessführung wesentlich einfacher beispielsweise durch Umschalten von Gasen bzw. gesteuertes ändern der Gasanteile (bspw. O₂ auf N₂) und / oder Umschalten von einem Target, bzw. gesteuertes ändern der Anteile der Targeteinspeisung, auf das andere geschehen, während bei CVD-Prozessen Zwischenspülungen sowie Anpassungen des Temperaturniveaus für einzelne Schichten eines mehrlagigen Schichtsystems notwendig sind.

## Patentansprüche

1. Hartstoffschicht als Arc-PVD Funktionsschicht (32) mit nicht voll durchreagierten Konglomeraten die metallische Anteile in der Schicht bilden, abgeschieden auf ein Werkstück (30) wobei die Funktionsschicht eine Schicht umfasst, die als elektrisch isolierendes Oxid ausgebildet ist, aus mindestens einem der Metalle (Me) aus den Übergangsmetallen der Nebengruppen IV, V, VI, des Periodensystems und Al, Si, Fe, Co, Ni, Y, wobei die Funktionsschicht (32) einen Gehalt an Edelgas von weniger als 2% aufweist,
**dadurch gekennzeichnet, dass** die Funktionsschicht (32) als Mehrfachschichtsystem (33) ausgebildet und zwischen der Funktionsschicht (32) und dem Werkstück (30) eine weitere Schicht, welche eine Zwischenschicht (31) bildet angeordnet ist, und diese insbesondere eine Haftschicht bildet und diese vorzugsweise eines der Metalle der Nebengruppen IV, V, und VI des Periodensystems und/oder Al, Si, Fe, Co, Ni, Co, Y, oder eine Mischung von diesen enthält.

2. Hartstoffschicht gemäss Anspruch 1, **dadurch gekennzeichnet, dass**, die Funktionsschicht (32) einen Gehalt an einem Halogen von weniger als 2% aufweist und vorzugsweise der Gehalt von Edelgas und Halogen zusammen weniger als 2% ist.

3. Hartstoffschicht gemäss einem der Ansprüche 1 oder 2, **dadurch gekennzeichnet, dass**, das Mehrfachschichtsystem (32) mindestens 20 Lagen aufweist, bevorzugt bis 500 Lagen.

4. Hartstoffschicht gemäss einem der vorangehenden Ansprüche, **dadurch gekennzeichnet, dass** die Dicke pro Lage im Bereich von 0.01 bis 0.5µm liegen, vorzugsweise im Bereich von 0.02 bis 0.1µm.

5. Hartstoffschicht gemäss einem der vorangehenden Ansprüche, **dadurch gekennzeichnet, dass** im Bereiche der einzelnen angrenzenden Lagen der Schichten Verläufe realisiert sind, wodurch die Übergänge gute Eigenschaften aufweisen.

6. Verfahren zum Beschichten eines Werkstückes (3) in einer Varkuumprozessanlage (1) mit einer Hartstoffschicht (32) die als Funktionsschicht abgeschieden wird, die als elektrisch isolierendes Oxid ausgebildet wird, aus mindestens einem der Metalle (Me) der Übergangsmetalle der Nebengruppe IV, V, VI des Periodensystems und Al, Si, Fe, Co, Ni, Y, wobei die Schicht mit einer ersten Arcverdampferquelle (5) mit erstem Target (5') abgeschieden wird die mit einer DC-Stromversorgung (13) betrieben wird welcher eine Pulsstromversorgung (16, 16') überlagert wird, wobei das erste Target (5') der Arcverdampferquelle (5) zumindest eines der Metalle enthält und der Arcverdampfungsprozess mit einem Reaktivgas mit einem derart geringen Edelgasanteil durchgeführt wird, dass die Funktionsschicht (32) einen Gehalt an Edelgas von weniger als 2% aufweist,
**dadurch gekennzeichnet, dass** das Verfahren ganz ohne räumliche Trennung zwischen Arcverdampferkathode bzw. Anode der Arcentladung und dem Substratbereich wo das Reaktivgas eingelassen wird und insbesondere kein Filter zwischen Arcverdampferkathode und Substrat zum Filtern von Spritzern (Droplets) eingesetzt wird.

7. Verfahren nach Anspruch 6, **dadurch gekennzeichnet, dass** der Arcverdampfungsprozess mit halogenhaltigen Verbindungen von weniger als 2% durchgeführt wird, vorzugsweise mit einem Anteil von Edelgas und Halogen zusammen von weniger als 2% durchgeführt wird.

8. Verfahren nach einem der Ansprüche 6 oder 7, **dadurch gekennzeichnet, dass** eine zweite Arcverdampferquelle (20) mit zweitem Target (20') eingesetzt wird, wobei erstes Target (5') und zweites Target (20') mit einer einzelnen Pulsstromversorgung (16) verbunden sind.

9. Verfahren nach einem der vorangehenden Ansprüche 6 bis 8, **dadurch gekennzeichnet, dass** die Vakuumprozessanlage (1) mit einer zusätzlichen Plasmaquelle ausgerüstet wird zur Erzeugung eines Niedervoltbogens mit Heisskathode.

10. Vakuumbehandlungsanlage zur Abscheidung eines elektrisch isolierenden Oxides mit einer ersten Arcverdampferquelle (5) mit erstem Target (5') wobei das erste Target (5') mindestens eines der Metalle (Me) der Übergangsmetalle der Nebengruppe IV, V, VI des Periodensystems und Al, Si, Fe, Co, Ni, Y enthält und die Vakuumbehandlungsanlage eine DC-Stromversorgung (13) und eine Pulsstromversorgung (16, 16') umfasst dergestalt, dass im Betrieb dem DC-Strom Pulse überlagert werden können, **dadurch gekennzeichnet, dass** die Vakuumprozessanlage mit einer zusätzlichen Plasmaquelle (9) zur Erzeugung eines Niedervoltbogens mit Heisskathode ausgestattet ist und die Anlage eine zweite Arcverdampferquelle (20) mit zweitem Target (20') umfasst, wobei erstes Target (5') und zweites Target (20') mit einer einzelnen Pulsstromversorgung (16) verbunden sind.

11. Vakuumbehandlungsanlage nach Anspruch 10, **dadurch gekennzeichnet, dass** die Heisskathode als Filament ausgebildet ist, welches in einer Ionisationskammer angeordnet ist, in welcher mit einem Gasleinlass (8) vorgesehen ist durch die ein Arbeitsgas zur Erzeugung einer Niedervoltbogenentladung, die sich in die Hauptkammer der Vakuumprozessanlage (1) erstreckt, eingelassen werden kann.

## Claims

1. Hard material layer deposited as an arc PVD function layer (32) on a workpiece (30), with incompletely reacted conglomerates which form metallic components in the layer, wherein the functional layer comprises a layer which is formed as an electrically isolating oxide of at least one of the metals (Me) from the transition metals of the subgroups IV, V, VI of the periodic system of elements and Al, Si, Fe, Co, Ni, Y, wherein the function layer (32) has a content of noble gas of less than 2%, **characterized in that** function layer (32) is formed as a multilayer system (33) and a further layer is arranged between function layer (32) and workpiece (30), forming an intermediate layer (31), particularly an adhesion layer, comprising preferably one of the metals from subgroups IV, V and VI of the periodic system of elements and/or Al, Si, Fe, Co, Ni, Y, or a mixture thereof.

2. Hard material layer according to claim 1, **characterized in that** the content of a halogen in the function layer (32) is less than 2% and preferably the content of noble gas and halogen together is less than 2%.

3. Hard material layer according to any of the preceeding claims, **characterized in that** the multilayer system (33) has at least 20 layers, preferably up to 500 layers.

4. Hard material layer according to any of the preceeding claims, **characterized in that** the thickness per layer is in the range from 0.01 to 0.5 µm, preferably in the range from 0.02 to 0.1 µm.

5. Hard material layer according to any of the preceeding claims, **characterized in that** in the region of adjoining single layers graduated layer gradients are realized, whereby layer transitions have good properties.

6. Method for coating a workpiece (3) in a vacuum processing plant (1) with a hard material layer (32) deposited as a function layer which is formed as an electrically isolating oxide of at least one of the metals (Me) of the transition metals of the subgroups IV, V, VI of the periodic system and Al, Si, Fe, Co, Ni, Co, Y, wherein the layer is deposited with a first arc vaporization source (5) with a first target (5'), the first arc vaporization source (5) being operated with a DC power supply (13) over which a pulsed current supply (16, 16') is superimposed, wherein the first target (5') of the arc vaporization source (5) contains at least one of the metals and the arc evaporation process is performed with a reactive gas having such a little content of noble gas that the function layer (32) has a percentage of noble gas of less than 2%, **characterized in that** the method is operated without any spatial separation between the cathode respectively the anode of the arc vaporization source and the substrate area where reactive gas is introduced and particularly no filter is applied to filter droplets.

7. Method according to claim 6, **characterized in that** the arc evaporation process is operated with less than 2% of halide containing compounds, preferably with a percentage of less than 2% of noble gas and halides together.

8. Method according to one of the claims 6 or 7, **characterized in that** a second arc evaporation source (20) with a second target (20') is used, wherein the first target (5') and the second target (20') are connected with a single pulsed current supply.

9. Method according to one of the claims 6 to 8, **characterized in that** the vacuum processing plant (1) is provided with an additional plasma source to produce a low voltage arc with a hot cathode.

10. Vacuum treatment equipment for the deposition of an electrically isolating oxide having a first arc vaporization source (5) with a first target (5'), wherein the first target (5') comprises at least one of the metals (Me) of the transition metals of the subgroups IV, V, VI of the periodic system and Al, Si, Fe, Co, Ni, Co, Y, and the vacuum treatment equipment comprises a DC power supply (13) and a pulsed current supply (16, 16'), whereby pulses can be superimposed to the DC-current, **characterized in that** the Vacuum treatment equipment is provided with an additional plasma source (9) to produce a low voltage arc with a hot cathode, and the equipment comprises a second target (20'), wherein first target (5') and second target (20') are connected with one single pulsed current supply (16).

11. Vacuum treatment equipment according to claim 19, **characterized in that** the hot cathode is designed as a filament, which is arranged in an ionization compartment being provided with a gas inlet (8), whereby a working gas can be introduced to generate a low voltage arc discharge which extends into the vacuum processing plant (1).

## Revendications

1. Couche dure sous forme de couche fonctionnelle Arc-PVD (32) avec des conglomérats qui n'ont pas pleinement réagi qui forment des éléments métalliques dans la couche, déposée sur une pièce à usiner (30), la couche fonctionnelle comprenant une couche réalisée sous la forme d'un oxyde électriquement isolant, à partir d'au moins un des métaux (Me) parmi les métaux de transition des sous-groupes IV, V, VI de la classification périodique et Al, Si, Fe, Co, Ni, Y, la couche fonctionnelle (32) présentant une teneur en gaz rare inférieure à 2 %, **caractérisée en ce que** la couche fonctionnelle (32) est réalisée sous la forme d'un système multicouches (33) et **en ce qu'**il est agencé entre la couche fonctionnelle (32) et la pièce à usiner (30) une autre couche formant une couche intermédiaire (31), cette couche formant en particulier une couche adhésive et contenant de préférence un des métaux des sous-groupes IV, V et VI de la classification périodique et/ou Al, Si, Fe, Co, Ni, Co, Y ou un mélange de ces derniers.

2. Couche dure selon la revendication 1, **caractérisée en ce que** la couche fonctionnelle (32) présente une teneur en halogène inférieure à 2 % et de préférence une teneur en gaz rare et en halogène ensemble inférieure à 2 %.

3. Couche dure selon l'une des revendications 1 ou 2, **caractérisée en ce que** le système multicouches (32) présente au moins 20 couches, de préférence jusqu'à 500 couches.

4. Couche dure selon l'une des revendications précédentes, **caractérisée en ce que** l'épaisseur par couche est comprise dans la plage allant de 0,01 à 0,5 µm, de préférence dans la plage allant de 0,02 à 0,1 µm.

5. Couche dure selon l'une des revendications précédentes, **caractérisée en ce qu'**il est réalisé dans les zones des différentes couches adjacentes des tracés qui permettent aux transitions de présenter de bonnes propriétés.

6. Procédé pour revêtir dans une installation de traitement sous vide (1) une pièce (3) d'une couche dure (32) qui est déposée en tant que couche fonctionnelle formée en tant qu'oxyde électriquement isolant, à partir d'au moins un des métaux (Me) des métaux de transition des sous-groupes IV, V, VI de la classification périodique et Al, Si, Fe, Co, NI, Y, la couche étant déposée avec une première source de vaporisation à arc (5) avec une première cible (5') qui est actionnée avec une alimentation électrique DC (13) qui est superposée à une alimentation pulsée (16, 16'), la première cible (5') de la source de vaporisation à arc (5) contenant au moins un des métaux et le processus de vaporisation à arc étant réalisé avec un gaz réactif avec une faible teneur en gaz rare de sorte que la couche fonctionnelle (32) présente une teneur en gaz rare inférieure à 2 %, **caractérisé en ce que** le procédé s'effectue sans aucune séparation physique entre la cathode ou l'anode du vaporisateur à arc de la décharge en arc et la zone de substrat où est admis le gaz réactif et en particulier sans aucun filtre entre la cathode du vaporisateur à arc et le substrat pour filtrer les gouttelettes (Droplets).

7. Procédé selon la revendication 6, **caractérisé en ce que** le processus de vaporisation à arc est réalisé avec des composés halogénés de moins de 2 %, de préférence avec une teneur en gaz rare et en halogène ensemble inférieure à 2 %.

8. Procédé selon l'une des revendications 6 ou 7, **caractérisé en ce qu'**il est utilisé une deuxième source de vaporisation à arc (20) avec une deuxième cible (20'), la première cible (5') et la deuxième cible (20') étant raccordées à une alimentation pulsée séparée (16).

9. Procédé selon l'une des revendications 6 à 8, **caractérisé en ce que** l'installation de traitement sous vide (1) est équipée d'une source plasma supplémentaire pour produire un arc basse tension avec une cathode chaude.

10. Installation de traitement sous vide pour déposer un oxyde électriquement isolant avec une première source de vaporisation à arc (5) avec une première cible (5'), la première cible (5') contenant au moins un des métaux (Me) des métaux de transition des sous-groupes IV, V, VI de la classification périodique et Al, Si, Fe, Co, Ni, Y et l'installation de traitement sous vide comprenant une alimentation électrique DC (13) et une alimentation pulsée (16, 16') de sorte que pendant le fonctionnement des impulsions puissent être superposées au courant DC, **caractérisée en ce que** l'installation de traitement sous vide est équipée d'une source plasma supplémentaire (9) pour produire un arc basse tension avec une cathode chaude et **en ce que** l'installation comprend une deuxième source de vaporisation à arc (20) avec une deuxième cible (20'), la première cible (5') et la deuxième cible (20') étant raccordées à une alimentation pulsée séparée (16).

11. Installation de traitement sous vide selon la revendication 10, **caractérisée en ce que** la cathode chaude est réalisée sous la forme d'un filament qui est agencé dans une chambre d'ionisation dans laquelle est prévue une entrée de gaz (8) à travers laquelle un gaz de travail peut être introduit pour produire une décharge en arc basse tension qui s'étend dans la chambre principale de l'installation de traitement sous vide (1).
